Europäisches Patentamt

European Patent Office

Office européen des brevets

(11) Veröffentlichungsnummer: **0 242 734**
**A2**

(12) **EUROPÄISCHE PATENTANMELDUNG**

(21) Anmeldenummer: 87105309.6

(22) Anmeldetag: **10.04.87**

(51) Int. Cl.⁴: **H01F 5/00** , H01F 7/20 ,
G01N 24/06 , G05D 23/19

(30) Priorität: **23.04.86 DE 3613682**

(43) Veröffentlichungstag der Anmeldung:
**28.10.87 Patentblatt 87/44**

(84) Benannte Vertragsstaaten:
**DE FR GB NL**

(71) Anmelder: **Bruker Analytische Messtechnik GmbH**
**Silberstreifen**
**D-7512 Rheinstetten-Forchheim(DE)**

(72) Erfinder: **Müller, Wolfgang, Dr.**
**Köslinerstrasse 48a**
**D-7500 Karlsruhe 1(DE)**
Erfinder: **Goebel, Klaus**
**Hebelstrasse 1**
**D-7512 Rheinstetten 3(DE)**

(74) Vertreter: **Patentanwälte Kohler - Schwindling - Späth**
**Hohentwielstrasse 41**
**D-7000 Stuttgart 1(DE)**

(54) Verfahren und Vorrichtung zum Kühlen eines resistiven Magnetsystems für Kernspintomographen.

(57) Ein Verfahren und eine Vorrichtung dienen zum Kühlen eines Magnetsystems, insbesondere eines Magnetsystems (50) eines Kernspintomographen, mit hoher Homogenität des Magnetfeldes. Eine Spule (51, 52, 53, 54) aus elektrisch leitendem Material mit endlichem Wirkwiderstand wird an ein Netzgerät (72) angeschlossen. Ein in wärmeleitendem Kontakt mit der Spule (51, 52, 53, 54) stehender Kühlkörper wird von einem Kühlmittel durchströmt. In einer ersten Betriebsart wird die Spule (51, 52, 53, 54) im Nennbetrieb mit einem Nennstrom gespeist und der wirksame Durchsatz des Kühlmittels wird auf einen Nennwert eingestellt.

Um außerhalb der Nutzungszeiten des Magnetsystems die Energiekosten niedrig zu halten, gleichzeitig aber Wartezeiten beim Wiedereinschalten des Magnetsystems so gering wie möglich zu halten, wird in einer zweiten Betriebsart im Bereitschaftsbetrieb die Spule (51, 52, 53, 54) mit einem Ruhestrom gespeist und der wirksame Durchsatz des Kühlmittels wird auf einen Ruhewert eingestellt.

Fig. 1

## Verfahren und Vorrichtung zum Kühlen eines resistiven Magnetsystems für Kernspintomographen

Die Erfindung betrifft ein Verfarhen zum Kühlen eines Magnetsystems, insbesondere eines Magnetsystems eines Kernspintomographen mit hoher Homogenität des Magnetfeldes, bei dem mindestens eine Spule aus elektrisch leitendem Material mit endlichem Wirkwiderstand an ein Netzgerät angeschlossen wird und ein in wärmeleitendem Kontakt mit der Spule stehender Kühlkörper von einem Kühlmittel durchströmt wird, wobei in einer ersten Betriebsart im Nennbetrieb die Spule vom Netzgerät mit einem Nennstrom gespeist und der wirksame Durchsatz des Kühlmittels auf einen Nennwert eingestellt wird.

Die Erfindung betrifft ferner eine Vorrichtung zur Durchführung dieses Verfahrens.

Für verschiedene Meßverfahren auf dem Gebiet der Physik und der Medizin ist es erforderlich, in einem relativ großen Volumen von beispielsweise 30x30x50 cm ein Magnetfeld relativ hoher Stärke, beispielsweise in der Größenordnung von B = 0,1 bis 3 Tesla und hoher Homogenität von beispielsweise $\Delta B/B = 10^{-5}$ in dem genannten Volumen zu erzeugen. Ein typisches Anwendungsbeispiel ist die Kernspintomographie, bei der ein menschlicher Körper dem genannten Konstantmagnetfeld sowie einem oder mehreren Hochfrequenzfeldern ausgesetzt wird, um flächenhafte Querschnittsdarstellungen des menschlichen Körpers zu erzeugen.

Es ist bekannt, zu diesem Zweck normalleitende oder auch supraleitende Magnetsysteme zu verwenden.

Üblicherweise werden als normalleitende Magnetsysteme Luftspulensysteme in Helmholtz-Anordnung oder Eisenmagnete verwendet, wobei zur Erzeugung der genannten Magnetfelder die Spulen des Magnetsystems von einem Netzgerät gespeist werden, das eine Ausgangsleitung in der Größenordnung von einigen 10 kW zur Verfügung stellen muß.

Es ist einsehbar, daß sich die Spulen bei dieser elektrischen Leistung beträchtlich erwärmen, so daß üblicherweise die Spulen aus metallischen Hohlprofilen hoher elektrischer Leitfähigkeit gewickelt werden, wobei das Hohlprofil von einem Kühlmittel, beispielsweise demineralisiertem Wasser, durchströmt wird. Das Kühlmittel wird mittels einer geeigneten Pumpe durch das Hohlprofil geschickt, und zwar vorzugsweise in einem geschlossenen Kreislauf, in den auch ein Wärmetauscher eingeschaltet ist. Durch diese direkte Kühlung ist es möglich, die Joul'sche Wärme, die vom Erregerstrom in den Spulen erzeugt wird, abzuführen.

Es ist ferner aus dem Buch von Montgomery "Solenoid Magnet Design", Wiley-Interscience, 1969, S. 55-57 bekannt, die Spulen aus den Hohlprofilen derart aufzubauen, daß das Hohlprofil in einer Flächenspirale gewickelt wird, so daß ein scheibenförmiges Spulenelement entsteht. Dabei befindet sich die Zuflußleitung und der elektrische Anschluß am äußeren Umfang der ersten Scheibe, im Innern erfolgt ohne Anschluß ein Übergang auf die Ebene der zweiten Scheibe, an deren äußeren Umfang wiederum die Abschlußleitung und der zweite elektrische Anschluß angebracht sind. Eine Erregerspule ist nun aus einer bestimmten Anzahl solcher Doppelschnecken aufgebaut. Mehrere dieser scheibenförmigen Flächenspulen können nun nebeneinandergelegt werden, um eine Spule des Magnetsystems zu bilden. Elektrisch werden die Flächenspulen in Serie geschaltet, so daß der Erregerstrom die Spulen nacheinander durchfließt. Hinsichtlich des Kühlmitteldurchflusses werden die einzelnen Flächenspulen paarweise gegensinnig in Reihe geschaltet und diese Reihenschaltungen dann wieder einander parallel angeordnet. Dies bedeutet, daß das Kühlmittel aus einer gemeinsamen Zuflußleitung, beispielsweise vom äußeren Umfang in jede zweite Flächenspule eintritt, diese durchströmt, am inneren Ende in die jeweils benachbarte Flächenspule gelangt und von dort zurück in eine gemeinsame Abflußleitung strömt. Innerhalb einer Doppelschnecke bildet sich beim Betrieb mit dem Nennstrom ein Temperaturprofil aus, das durch die Energiebilanz und Wärmeübergänge in der Spule bestimmt wird. Bemerkenswert ist, daß innerhalb der Spule deutlich höhere Temperaturen als die Austrittstemperatur des Kühlmediums auftreten können.

Die vorstehend beschriebenen bekannten Magnetsysteme sind jedoch mit zwei einander widerstreitenden Problemen behaftet.

Aufgrund der sehr hohen Versorgungsleistungen, die zum Betrieb der Magnetsysteme erforderlich sind, entstehen beträchtliche Energiekosten, wenn die bekannten Magnetsysteme im Dauerbetrieb bei ihren Nennwerten betrieben werden.

Wenn man andererseits, um Energiekosten zu sparen, die Magnetsysteme außerhalb der üblichen Betriebszeiten, insbesondere also während der Nacht, abschaltet, hat dies zur Folge, daß die Magnetsysteme sich über Nacht abkühlen und nach dem Einschalten am Morgen des nächsten Arbeitstages erst wieder warm werden müssen.

Um die eingangs genannten Betriebsbedingungen zu erreichen, insbesondere die erforderliche extrem hohe Homogenität des Magnetfeldes, ist es erforderlich, daß ein kaltes Magnetsystem sich über mehrere Stunden im Nennbetrieb erwärmt, ehe langzeitstabile Feldwerte erreicht sind.

Der Erfindung liegt daher die Aufgabe zugrunde, ein Verfahren der eingangs genannten Art dahingehend weiterzubilden, daß einerseits die Energiekosten gegenüber einem kontinuierlich durchlaufenden Betrieb bei Nennwerten deutlich vermindert werden, andererseits aber keine oder nur geringe Wartezeiten beim Wiedereinschalten des Magnetsystems einzuhalten sind.

Diese Aufgabe wird nach dem eingangs genannten Verfahren dadurch gelöst, daß in einer zweiten Betriebsart im Bereitschaftsbetrieb die Spule vom Netzgerät mit einem Ruhestrom gespeist und der wirksame Durchsatz des Kühlmittels auf einen Ruhewert eingestellt wird.

Gemäß der eingangs genannten Vorrichtung wird diese Aufgabe dadurch gelöst, daß das Netzgerät und Kühlmittel-Versorgungsgeräte mit einem Zeitschaltgerät in Wirkverbindung stehen, dessen Steuersignale den Ausgangsstrom des Netzgerätes und den wirksamen Durchsatz der Versorgungsgeräte beeinflussen.

Die der Erfindung zugrundeliegende Aufgabe wird damit vollkommen gelöst, weil die Betriebstemperatur des Magnetsystems weitgehend konstant gehalten werden kann, indem gleichzeitig der Erregerstrom und auch die wirksame Kühlung des Kühlsystems reduziert werden, so daß sich zwar ebenfalls ein Wärmegleichgewicht bildet, jedoch bei deutlich verminderter Energiezufuhr und Energieabfuhr.

Es können auf diese Weise erhebliche Kosten für elektrische Energie gespart werden, weil zum Aufrechterhalten der Betriebstemperatur des Magnetsystems nur eine verhältnismäßig kleine elektrische Leistung erforderlich ist, sofern gleichzeitig die Wirksamkeit des Kühlsystems entsprechend reduziert wird. Im Extremfall kann man auch das Kühlsystem ganz abschalten und das Magnetsystem mit einem sehr geringen Ruhestrom auf Betriebstemperatur halten.

Besonders bevorzugt ist jedoch, wenn sowohl der Erregerstrom wie auch die Wirksamkeit des Kühlsystems auf einen endlichen Ruhewert eingestellt werden, weil sich dann auch bezüglich der Wärmeverteilung im Magnetsystem Verhältnisse einstellen, die den realen Verhältnissen im Nennbetrieb entsprechen.

Wird nämlich das Magnetsystem mit Nennstrom und wirksamen Nenndurchsatz des Kühlmittels betrieben, so bildet sich entlang des Weges des Kühlmittels selbstverständlich ein Temperaturgefälle, weil das Kühlmittel sich auf seinem Weg durch die Erregerspule hindurch naturgemäß erwärmt und daher die Kühlwirkung auf diesem Weg nach und nach abnimmt. Würde man nun den wirksamen Durchsatz des Kühlmittels auf Null reduzieren, würde sich zwar makroskopisch eine bestimmte Ruhetemperatur des Magnetsystems einstellen, mikroskopisch wäre jedoch die Temperaturverteilung innerhalb des Magnetsystems von derjenigen im Nennbetrieb unterschiedlich, so daß zur Herstellung dieser Temperaturverteilung wiederum eine gewisse Anlaufzeit beim Hochfahren des Erregerstroms und des wirksamen Durchsatzes des Kühlmittels auf Nennwerte einzuhalten wäre.

Bei Ausführungsformen der Erfindung wird der wirksame Durchsatz des Kühlmittels entweder durch Variation der Kühlmitteltemperatur und/oder durch Variation der pro Zeiteinheit durchlaufenden Menge des Kühlmittels eingestellt.

Dies kann bei Ausführungsformen der erfindungsgemäßen Vorrichtung dadurch erreicht werden, daß man entweder eine Kühlmittelpumpe in ihrer Drehzahl einstellt bzw. ein Einstellventil in einer Kühlmittel-Druckleitung verstellt oder aber indem man einen Wärmetauscher in seiner Wirksamkeit verstellt, beispielsweise durch Variation des Durchsatzes des Primär-Kühlmittels, durch Variation der Drehzahl eines Kühlgebläses bei einem Luft-Wärmetauscher oder dergleichen.

Besonders bevorzugt ist eine Ausführungsform des erfindungsgemäßen Verfahrens, bei dem die Nennwerte während des Tages und die Ruhewerte während der Nacht eines Arbeitstages eingestellt werden.

Diese Maßnahme hat den Vorteil, daß über die ganze betriebsfreie Nacht der kostengünstige Ruhebetrieb des Magnetsystems eingestellt werden kann, während bei entsprechend ausgelegten Verfahrensparametern am Morgen des Arbeitstages ohne oder zumindest ohne nennenswerte Wartezeiten auf Nennbetrieb umgeschaltet werden kann. Es ist aber selbstverständlich auch möglich, diese Umschaltung zwischen Nennbetrieb und Ruhebetrieb auch in Arbeitspausen, beispielsweise während der Mittagspause o.dgl. vorzunehmen.

Eine weitere bevorzugte Ausführungsform des erfindungsgemäßen Verfahrens zeichnet sich dadurch aus, daß der Übergang von den Ruhewerten auf die Nennwerte entlang eines stetig ansteigenden oder gestuften Verlaufes eingestellt wird.

Diese Maßnahme hat den Vorteil, daß eine noch bessere Annäherung an die Nennwerte aus dem Ruhebetrieb heraus gelingt, und man kann beispielsweise durch eine geeignete Zeitschaltuhr bereits einige Zeit vor Beginn der Arbeitszeit den Erregerstrom und den wirksamen Kühlmitteldurchsatz kontinuierlich von den Ruhewerten auf die Nennwerte erhöhen.

Schließlich wird das erfindungsgemäße Verfahren besonders bevorzugt bei den bereits eingangs geschilderten bekannten Magnetsystemen eingesetzt, bei denen die Spulen aus Hohlprofilen zu Paaren von Flächenspiralen gewickelt sind, die in der beschriebenen Weise elektrisch und kühltechnisch miteinander verschaltet sind.

Der besondere Vorteil bei diesem Typ Magnetsysteme liegt nämlich darin, daß sich über den Weg der Hohlprofile besonders deutliche Temperaturgradienten im Nennbetrieb einstellen, weil sich das durchströmende Kühlmittel auf der relativ langen Wegstrecke durch die Hohlprofile hindurch beträchtlich erwärmt. Dies bedeutet, daß typischerweise dann, wenn das Kühlmittel jeweils vom Außenumfang der Flächenspiralen eingespeist wird, sich an der Innenumfangsseite der Flächenspulen eine um beispielsweise 10° bis 15° höhere Temperatur einstellt, wobei dieser Temperaturgradient selbstverständlich Auswirkungen auf die Homogenität des Magnetfeldes hat, weil sämtliche Elemente des Magnetsystems einen endlichen Wärmeausdehnungskoeffizienten haben. Würde nun die im Nennbetrieb bestehende Temperaturverteilung geändert, würden sich unterschiedliche Bereiche der Spule ausdehnen bzw. zusammenziehen, so daß selbst bei einer mittleren konstanten Temperatur des Magnetsystems erhebliche Änderungen in der Homogenität des Magnetfeldes eintreten würden. Durch die gezielte Reduzierung des wirksamen Kühlmitteldurchsatzes auf einen endlichen Wert bei gleichzeitiger Reduzierung des Erregerstroms würde dieser Effekt jedoch vollkommen vermieden, weil der grundsätzliche Wärmemechanismus über die Länge der Hohlprofile erhalten bleibt.

Eine gute Wirkung wird schließlich dadurch erzielt, daß das Zeitschaltgerät das Magnetsystem in der ersten Betriebsart mit dem Netzgerät und dem Kühlmittel-Versorgungsgerät hoher Leistung (Nennleistung) verbindet, während es in der zweiten Betriebsart das Magnetsystem mit Geräten niedrigerer Leistung (Ruheleistung) verbindet.

Dies hat den Vorteil, daß für beide Betriebsarten Geräte eingesetzt werden können, die in ihren - im wesentlichen konstanten - Leistungsdaten im Wirkungsgrad jeweils optimiert sind.

Weitere Vorteile der Erfindung ergeben sich aus der Beschreibung und der beigefügten Zeichnung.

Es versteht sich, daß die vorstehend beschriebenen und die nachstehend noch genannten Vorteile nicht nur in der jeweils angegeben Kombination, sondern auch in anderen Kombinationen oder auch in Alleinstellung verwendbar sind, ohne den Rahmen der vorliegenden Erfindung zu verlassen.

Ein Ausführungsbeispiel der Erfindung ist in der Zeichnung dargestellt und wird in der nachfolgenden Beschreibung näher erläutert. Es zeigen:

Fig. 1 ein stark schematisiertes Blockschaltbild eines Magnetsystems, wie es in Verbindung mit dem erfindungsgemäßen Verfahren verwendet werden kann;

Fig. 2 eine Seitenansicht in Richtung der Pfeile II-II von Fig. 1;

Fig. 3 ein Schaltschema zur Erläuterung der elektrischen und der kühltechnischen Verschaltung von Einzelspulen des Magnetsystem gemäß den Fig. 1 und 2;

Fig. 4 eine schematische Darstellung in stark vergrößertem Maßstab eines Paares von nebeneinanderliegenden Flächenspulen bei einem Magnetsystem gemäß den Fig. 1 und 2;

Fig. 5 ein Diagramm zur Veranschaulichung des Temperaturgefälles entlang eines in Fig. 4 dargestellten Kühlmittelweges;

Fig. 6 und 7 Diagramme zur Veranschaulichung des zeitlichen Verlaufes eines Erregerstroms und eines wirksamen Kühlmitteldurchsatzes bei einem Magnetsystem erfindungsgemäßer Art.

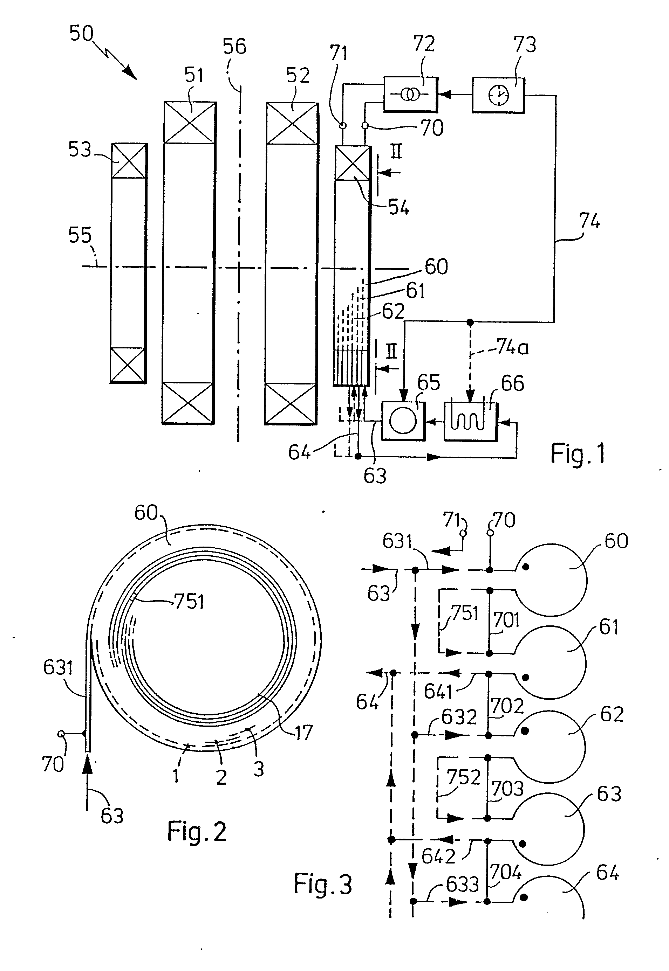

In Fig. 1 bezeichnet 50 insgesamt ein Magnetsystem, das als Doppel-Helmholtz-System mit zwei symmetrischen Paaren von Spulen 51, 52; 53, 54 ausgebildet ist, die zu einer Längsachse 55 und einer Hochachse 56 symmetrisch angeordnet sind.

Wie andeutungsweise in der Spule 54 eingezeichnet, besteht diese Spule 54 ebenso wie die anderen Spulen 51 bis 53 aus mehreren, in Richtung der Längsachse 55 aufeinanderliegenden Scheiben 60, 61, 62, von denen jede zweite an einen Kühlmittelzufluß 63 und die jeweils andere an einen Kühlmittelab fluß 64 angeschlossen sind, so daß Doppelschnecken als Baueinheiten entstehen.

Der Kühlmittelzufluß 63 und der Kühlmittelabfluß 64 sind Teile eines geschlossenen Kühlmittelkreislaufs, der weiterhin eine Kühlmittelpumpe 65 sowie einen Wärmetauscher 66 aufweist.

Die Spule 54 ist ebenso wie die anderen Spulen 51 bis 53 mit Anschlußklemmen 70, 71 versehen, an die ein Netzgerät 72 angschlossen ist.

Das erfindungsgemäße System weist ferner ein Zeitschaltgerät 73 auf, das in Abhängigkeit von der Tageszeit Steuersignale erzeugt und diese dem Netzgerät 72 sowie über eine Steuerleitung 74 der Kühlmittelpumpe 65 und/oder über eine Steuerleitung 74a dem Wärmetauscher 66 zuführt.

Aus der Seitenansicht der Fig. 2 erkennt man, daß die Scheibe 60 als Flächenspirale ausgebildet ist, indem ein elektrischer Leiter, beispielsweise ein Kupferhohlprofil, von außen nach innen in Windungen 1, 2, 3 ... 17 spiralig verläuft. Am Innenumfang der Scheibe 60 erkennt man eine Verbindung 751, die zu dem entsprechenden inneren Ende der benachbarten Scheibe 61 führt. Am Außenumfang der Scheibe 60 ist das Kupferhohlprofil mit einer Stichleitung 631 nach außen geführt, die mit dem Kühlmittelzufluß 63 verbunden und ferner an die Anschlußklemme 70 angeschlossen ist.

Die elektrische und kühltechnische Verschaltung der einzelnen Flächenspiralen der Scheiben 60, 61, 62, 63, 64 ... ist schematisch in Fig. 3 dargestellt.

Hinsichtlich der elektrischen Verschaltung erkennt man leicht, daß die Flächenspiralen der Scheiben 60, 61, 62 ... in Reihe geschaltet sind, wozu Verbindungsleitungen 701, 702, 703, 704 zusammen mit den Leitungslängen der Flächenspiralen einen geschlossenen Strompfad von der Anschlußklemme 70 zur Anschlußklemme 71 bilden.

In kühltechnischer Hinsicht sind die Hohlprofile zweier nebeneinanderliegender Scheiben 60, 61 bzw. 62, 63 bzw. 64 ... gegensinnig in Serie geschaltet, wozu die bereits erwähnte Verbindung 751 sowie entsprechende Verbindungen 752 ... vorgesehen sind. Die Scheiben 60/61 bzw. 62/63 usw. bilden somit jeweils eine Doppelschnecke. Diese gegensinnigen Serienschaltungen 60/61, 62/63 ... sind mittels Stichleitungen 631, 632 ... an den Kühlmittelzufluß 63 bzw. an ihrem anderen Ende mit Stichleitungen . 641, 642 ... an den Kühlmittelabfluß 64 angeschlossen.

Insgesamt bedeutet dies, daß die Flächenspiralen der Scheiben 60, 61, 62 ... in Reihenschaltung nacheinander vom Erregerstrom durchflossen werden, während das Kühlmittel eine Anzahl von Einzel-Kühlkreisläufen parallel durchströmt, die der halben Anzahl der Scheiben 60, 61, 62 ... entspricht.

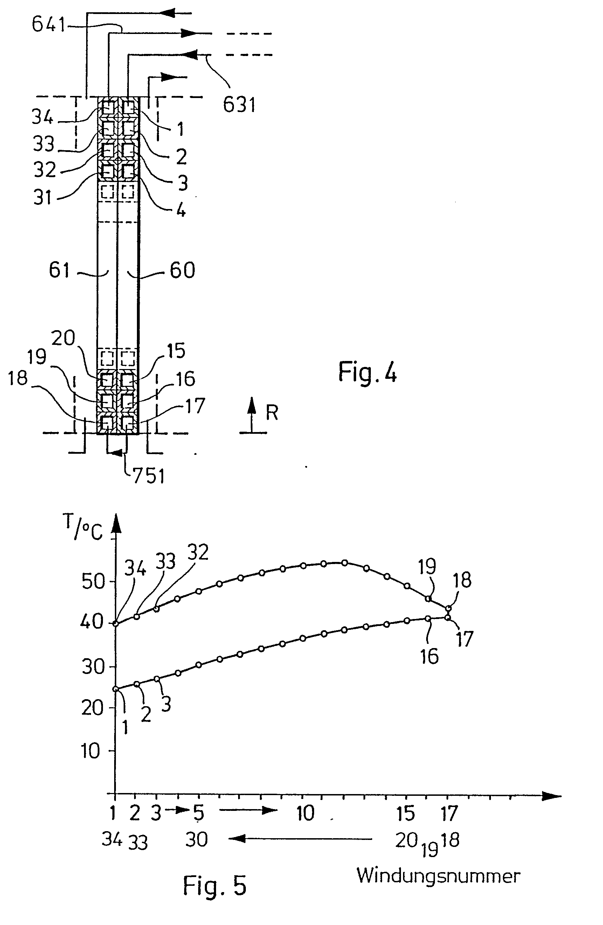

Fig. 4 zeigt die Verhältnisse dieser Typ-Magnetsysteme 50 der beschriebenen Art werden mit einer Nennleistung in der Größenordnung von einigen 10 kW betrieben, um in Räumen von mehreren Dezimetern Abmessung Magnetfelder hoher Homogenität einer Stärke von bis zu mehreren Tesla zu erzeugen.

Die hierzu erforderlichen Nennströme, die vom Netzgerät 72 in die Spulen 51 bis 54 eingespeist werden, bewirken eine erhebliche Erwärmung dieser Spulen. Diese Wärme wird durch das Kühlmittel abgeführt, das den zu Fig. 4 beispielhaft beschriebenen Weg durch die Spulen 51 bis 54 nimmt.

Es ist nun leicht einsehbar, daß das in die erste Windung 1 eintretende Kühlmittel eine verhältnismäßig niedrige Temperatur aufweist und sich dann auf seinem Weg durch die Windungen 1 ... 34 erwärmt, um dann über die Stichleitung 641 wieder auszutreten.

Fig. 5 zeigt den Temperaturverlauf über die einzelnen Windungen 1 ... 34.

Man erkennt aus Fig. 5, daß die Temperatur, von der Anfangswindung 1 an betrachtet, zunächst von einem Anfangswert von beispielsweise 25°C zunächst langsam und bis zur letzten Windung 17 der Scheibe 60 ansteigt. Diese Endtemperatur beträgt beispielsweise 42°C. Auf ihrem weiteren Weg durch die Windungen 18 und folgende erhöht sich nun die Temperatur des Kühlmittels auf weit über 50°C, weil das Kühlmittel nun an Windungen 14, 15, 16 der Scheibe 60 vorbeiströmt, die ebenfalls bereits auf relativ hoher Temperatur liegen. Im Nachfolgenden strömt das Kühlmittel nun jedoch durch Windungen der Scheibe 61, die an kältere Windungen der Scheibe 60 angrenzen, und die Temperatur des Kühlmittels fällt wieder deutlich bis auf den Wert von etwa 40°C. Die Eintrittstemperatur des Kühlwassers beträgt bei dem gewählten

stimmte mechanische Ausdehnung der Windungen 1 ... 34 umsetzt, weil das Material des Kupferhohlprofils immer eine endlichen Wärmeausdehnungskoeffizienten hat.

Das Temperaturprofil gemäß Fig. 5 setzt sich somit in ein entsprechendes Wärmeausdehnungsprofil sämtlicher Spulen 51 bis 54 um, das bei Erreichen der Nennbedingungen konstant bleibt und zu einer entsprechenden Nenn-Felderverteilung im Probenraum des Magnetsystems 50 führt.

Schaltet man nun das Netzgerät 72 am Ende des Arbeitstages völlig ab, so kühlen sich die Windungen 1 ... 34 allmählich auf den Wert der Umgebungstemperatur ab und nehmen schließlich im Verlaufe der Nacht sämtlich einen gleichen Temperaturwert von beispielsweise 20°C ein.

Wird nun das Magnetsystem 50 zu Beginn des nächsten Arbeitstages durch Einschalten des Netzgerätes 72 wieder in Betrieb genommen, so erwärmen sich die Windungen 1 ... 34 allmählich, es dauert jedoch mehrere Stunden, bis sich der in Fig. 5 dargestellte Endzustand des Temperaturprofils eingestellt hat.

Man kann nun zwar das Temperaturprofil gemäß Fig. 5 dadurch annähern, daß man das Magnetsystem 50 am Ende des Arbeitstages nicht vollkommen abschaltet, sondern durch gleichmäßige Erwärmung auf einer gemeinsamen mittleren Temperatur von beispielsweise 40° hält, indem man beispielsweise den Kühlmittelfluß vollkommen abschaltet und einen geringen Ruhestrom in die Spulen 51 bis 54 einspeist, der gerade eine Erwärmung dieser Spulen 51 bis 54 auf den genannten Temperaturwert zur Folge hat. Für hochpräzise Messungen reicht dies jedoch nicht aus. Wird nämlich zu Beginn des nächsten Arbeitstages der Ruhestrom wieder auf den Nennstrom erhöht und gleichzeitig der Kühlmittelkreislauf eingeschaltet, so muß sich zunächst, ausgehend von einer mittleren Temperatur von beispielsweise 40° sämtlicher Windungen 1 ... 34, das in Fig. 5 dargestellte definierte Temperaturprofil ausbilden. Dies dauert zwar nicht solange, wie wenn sich das gesamte Magnetsystem 50 von Raumtemperatur auf dieses Temperaturprofil erwärmen müßte, die erforderliche Wartezeit, bis stabile Bedingungen vorliegen, ist jedoch immer noch relativ lang.

Es ist daher das Zeitschaltgerät 73 sowohl mit dem Netzgerät 72 wie auch mit der Kühlmittelpumpe 65 und/oder dem Wärmetauscher 66 verbunden, um den Betriebszustand der beiden genannten Einheiten in vorgegebener Weise abzusenken.

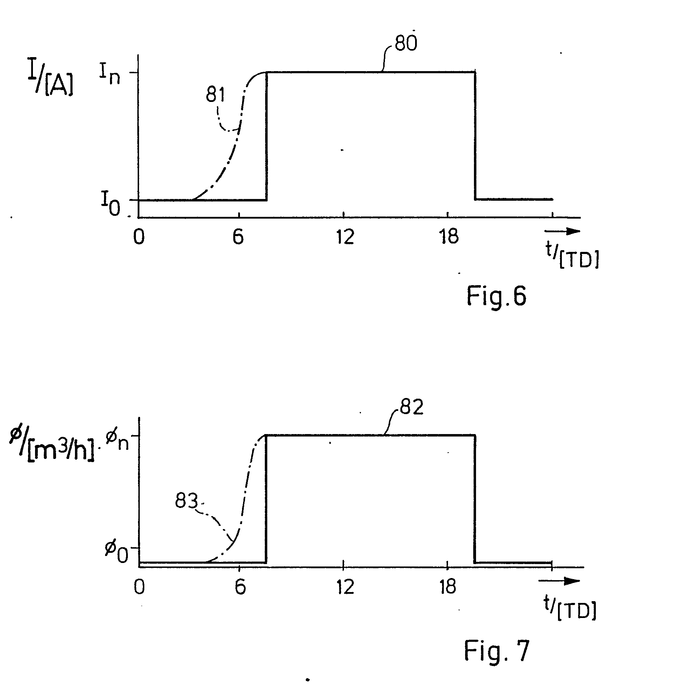

Beispiele hierfür sind den Fig. 6 und 7 zu entnehmen, wo Fig. 6 den zeitlichen Verlauf des Stromes I über der Tageszeit und Fig. 7 den zeitlichen Verlauf des wirksamen Durchsatzes $\phi$ über der Tageszeit t darstellt.

Mit 80 ist ein Verlauf des Erregerstromes I bezeichnet, und man erkennt, daß bis zu einer Tageszeit von beispielsweise 8 Uhr morgens ein Ruhestrom $I_o$ eingestellt wird, der um 8 Uhr morgens auf den Nennwert $I_n$ erhöht wird. Nach Beendigung des Arbeitstages, beispielsweise um 19 Uhr, wird der Erregerstrom I wieder auf den Ruhestrom $I_o$ zurückgenommen.

Entsprechendes zeigt Fig. 7 mit dem Verlauf 82 für den wirksamen Durchsatz $\phi$, der zu den genannten Zeiten vom Ruhedurchsatz $\phi_o$ auf den Nenndurchsatz $\phi_n$ und nach Beendigung des Arbeitstages wieder auf den Ruhewert $\phi_o$ zurückgenommen wird.

Mit den Verläufen 81 und 83 in den Fig. 6 bzw. 7 ist noch angedeutet, daß insbesondere die Erhöhung der Betriebswerte zu Beginn des Arbeitstages nicht schlagartig erfolgen muß, sondern daß vielmehr noch ein kontinuierliches oder stufenweises Anfahren der Nennwerte $I_n$ und $\phi_n$ möglich ist. Hierzu kann das Zeitschaltgerät 73 in geeigneter Weite programmiert werden, um beispielsweise um 4 Uhr morgens bereits langsam mit der Erhöhung der Betriebswerte zu beginnen.

In Fig. 6 wurde angenommen, daß $I_o$ etwa 1/7 des Betriebsstroms $I_n$ beträgt. Da bekanntlich die Leistung an einem näherungsweise konstanten Wirkwiderstand quadratisch mit dem Strom zusammenhängt, bedeutet dies, daß das Verhältnis von $\phi_o/\phi_n$ in Fig. 7 etwa 1/49 beträgt. Die Leistung im Ruhezustand kann daher beträchtlich reduziert werden, ohne daß das Temperaturprofil gemäß Fig. 5 in seiner Form geändert wird. Voraussetzung für ein im Ruhezustand weitgehend ungeändertes Temperaturprofil ist, daß die Leistung im Ruhezustand größer als die Verluste durch Wärmestrahlung und Wärmeleitung ist.

Auch zeigt Fig. 7 mit einem Verlauf 82, daß beispielsweise der wirksame Durchsatz $\phi$ auf sehr geringe Werte reduziert werden kann, so daß nahezu die gesamte eingesetzte elektrische Energie zur Aufrechterhaltung des Temperaturprofils gemäß Fig. 5 eingestzt wird und der geringe verbleibende wirksame Kühlmitteldurchsatz nur noch bewirkt, daß das Temperaturprofil gemäß Fig. 5 in seiner Form erhalten bleibt.

Wenn in der vorstehenden Erläuterung von wirksamem Kühlmitteldurchsatz gesprochen wurde, so versteht sich für den Fachmann, daß hiermit sowohl die Temperatur des Kühlmittels wie auch dessen Mengendurchsatz pro Zeiteinheit gemeint sein kann. Es versteht sich ferner, daß die Beeinflussung des wirksamen Kühlmitteldurchsatzes sowohl durch Einstellen der Drehzahl der Kühlmittelpumpe 65 wie auch durch Betätigen eines in Fig. 1 nicht dargestellten Einstellventils in einer Kühlmittel-Druckleitung erfolgen kann. Auch kann der Wärmetauscher 66 in geeigneter Weise beeinflußt werden, insbesondere um die Temperatur des Kühlmittels zu beeinflussen, indem beispielsweise bei einem Luftkühler die Drehzahl des Ventilators variiert wird oder dergleichen.

Es versteht sich schließlich ferner, daß das geschilderte Ausführungsbeispiel mit in Form von Flächenspiralen gewikkelten Kupferhohlprofilen zwar eine besonders bevorzugte Ausführungsform der Erfindung ist, die Erfindung jedoch keinesfalls einschränkt. Die Erfindung kann vielmehr generell bei allen Elektromagneten mit Kühlkörpern verwendet werden, die von Kühlmittel durchflossen werden. Die Spulen können z.B. eine in axialer Draufsicht rechteckige oder bananenförmige Gestalt aufweisen. Die Leitungsführung kann in der beschriebenen Doppelschneckentechnik aber auch in der bekannten Einfachschneckentechnik oder in Doppelhelixform erfolgen, wie sie z.B. in dem eingangs erwähnten Buch von Montgomery auf S. 56 beschrieben wird.

Dies gilt auch für Ausführungen von Magneten, bei denen einzelne Lagen von Magneten, bei denen einzelne Lagen von massiven Kupferdrähten sich mit Lagen von Kühlkörpern oder gewickelten Kupferhohlprofilen·abwechseln, oder auch für Spulen von Elektromagneten, die nur an den Seiten mit flächenhaften Kühlkörpern versehen sind.

**Ansprüche**

1. Verfahren zum Betreiben eines Magnetsystems, insbesondere des Magnetsystems eines Kernspintomographen mit hoher Homogenität des Mangnetfeldes, bei dem mindestens eine Spule aus elektrisch leitendem Material mit endlichem Wirkwiderstand mit einem ein Magnetfeld vorgegebener Stärke erzeugenden Nennstrom gespeist und ein in wärmeleitendem Kontakt mit der Spule stehender Kühlkörper vom einem Kühlmittel durchströmt wird, dessen Durchsatz so eingestellt ist, daß sich innerhalb der Spule ein spezifisches Temperaturprofil einstellt,
dadurch gekennzeichnet,
daß in Arbeitspausen, insbesondere über Nacht, während denen das Magnetfeld vorgegebener Stärke nicht benötigt wird, die Stärke des die Spule durchfließenden Stromes auf eine vorgegebene Ruhestromstärke ($I_o$) zurückgenommen und gleichzeitig der Durchsatz des Kühlmittels auf einen ebenfalls vorgegebenen Ruhewert ($\phi_n$) eingestellt wird, bei dem das spezifische Temperaturprofil im wesentlichen aufrechterhalten bleibt.

2. Verfahren nach Anspruch 1 dadurch gekennzeichnet, daß der Übergang von den Ruhewerten ($I_o, \phi_o$) auf die Nennwerte ($I_n, \phi_n$) entlang eines stetig ansteigenden oder gestuften Verlaufes (81, 83) eingestellt wird.

3. Verfahren nach einem der Ansprüche 1 und 2, dadurch gekennzeichnet, daß das Kühlmittel durch Hohlprofile aus elektrisch leitendem Material mit endlichem Wirkwiderstand geschickt wird und daß die mindestens eine Spule (51, 52, 53, 54) aus den Hohlprofilen gewickelt ist.

4. Verfahren nach Anspruch 3, dadurch gekennzeichnet, daß die Hohlprofile als Flächenspiralen (1, 2, 3 ... 17; 18, 19, 20 ... 34) gewickelt sind; daß mehrere Flächenspiralen (1, 2, 3 ... 17; 18, 19, 20 ... 34) als Scheiben (60, 61, 62) nebeneinander die Spulen (51, 52, 53, 54) bilden und daß das Kühlmittel von einem Ende (1) einer Flächenspule (1, 2, 3 ... 17) zu deren entgegengesetztem Ende (17), von dort zum entsprechenden Ende (18) der benachbarten Flächenspirale (18, 19, 20 ... 34) und von dort zu deren einem Ende (34) geschickt wird, wobei mehrere der so gebildeten Paare von Flächenspulen (1, 2, 3 ... 17; 18, 19, 20 ... 34) parallel zwischen einem gemeinsamen Kühlmittelzufluß (63) und einem gemeinsamen Kühlmittelabfluß (64) angeordnet sind.

5. Vorrichtung zur Durchführung des Verfahrens nach einem der Ansprüche 1 bis 4, dadurch gekennzeichnet, daß ein Netzgerät (72) und Kühlmittel-Versorgungsgeräte (60, 65) mit einem Zeitschaltgerät (73) in Wirkverbindung stehen, dessen Steuersignale den Ausgangsstrom (I) des Netzgerätes (72) und den wirksamen Durchsatz ($\phi$) der Versorgungsgeräte (60, 65) beeinflussen.

6. Vorrichtung nach Anspruch 5, dadurch gekennzeichnet, daß das Zeitschaltgerät (73) mit einer Kühlmittelpumpe (65) in Wirkverbindung steht.

7. Vorrichtung nach Anspruch 5 oder 6, dadurch gekennzeichnet, daß das Zeitschaltgerät (73) mit einem Einstellventil in einer Kühlmittel-Druckleitung in Wirkverbindung steht.

8. Vorrichtung nach einem der Ansprüche 5 bis 7, dadurch gekennzeichnet, daß das Zeitschaltgerät (73) mit einem Wärmetauscher (60) zum Einstellen der Kühlmitteltemperatur am Ausgang des Wärmetauschers (60) in Wirkverbindung steht.

9. Vorrichtung nach Anspruch 5, dadurch gekennzeichnet, daß das Zeitschaltgerät (73) das Magnetsystem (50) in der ersten Betriebsart mit dem Netzgerät (72) und dem Kühlmittel-Versorgungsgerät (60, 65) hoher Leistung (Nennleistung) verbindet, während es in der zweiten Betriebsart das Magnetsystem (50) mit Geräten niedriger Leistung (Ruheleistung) verbindet.

Fig.1

Fig.2

Fig.3

Fig. 4

Fig. 5

Windungsnummer

Fig.6

Fig. 7